# EUROPÄISCHE PATENTSCHRIFT

(11) **EP 4 420 496 B1**
(45) Veröffentlichungstag und Bekanntmachung des Hinweises auf die Patenterteilung: **28.01.2026**
(21) Anmeldenummer: 22793162.3
(22) Anmeldetag: 27.09.2022
(51) Int. Cl.: H10N 30/01, H10N 30/20, H10N 30/30, H10N 30/80, H04R 31/00, H04R 17/00, H04R 17/02

(54) **MIKROMECHANIKELEMENT FÜR EINEN MIKROELEKTROMECHANISCHEN WANDLER, VERFAHREN ZUM HERSTELLEN EINES MIKROMECHANIKELEMENTS, VERFAHREN ZUM BETREIBEN EINES MIKROMECHANIKELEMENTS, VORRICHTUNG UND MIKROELEKTROMECHANISCHER WANDLER**
MICROMECHANICAL ELEMENT FOR A MICROELECTROMECHANICAL TRANSDUCER, METHOD FOR PRODUCING A MICROMECHANICAL ELEMENT, METHOD FOR OPERATING A MICROMECHANICAL ELEMENT, DEVICE AND MICROELECTROMECHANICAL TRANSDUCER
UN ÉLÉMENT MICROMÉCANIQUE POUR UN TRANSDUCTEUR MICRO-ÉLECTROMÉCANIQUE, PROCÉDÉ DE FABRICATION D'UN ÉLÉMENT MICROMÉCANIQUE, PROCÉDÉ DE FONCTIONNEMENT D'UN ÉLÉMENT MICROMÉCANIQUE, DISPOSITIF ET TRANSDUCTEUR MICRO-ÉLECTROMÉCANIQUE

(30) Priorität: 21.10.2021 DE 102021211857
(43) Veröffentlichungstag der Anmeldung: 28.08.2024
(73) Patentinhaber: Robert Bosch GmbH, 70442 Stuttgart (DE)
(72) Erfinder: SCHELLING, Christoph, 70619 Stuttgart (DE); PANTEL, Daniel, 74395 Mundelsheim (DE)
(86) Internationale Anmeldenummer: PCT/EP2022/076832
(87) Internationale Veröffentlichungsnummer: WO 2023/066622

(56) Entgegenhaltungen:
- EP-A1- 3 809 476
- DE-A1- 102017 109 575
- US-A1- 2008 122 317

## Beschreibung

### Stand der Technik

Der Ansatz geht von einem Mikromechanikelement für einen mikroelektromechanischen Wandler, einem Verfahren zum Herstellen eines Mikromechanikelements, einem Verfahren zum Betreiben eines Mikromechanikelements, einer Vorrichtung und einen mikroelektromechanischen Wandler nach Gattung der unabhängigen Ansprüche aus. Gegenstand des vorliegenden Ansatzes ist auch ein Computerprogramm. Mikroelektromechanische Wandler bilden eine unverzichtbare technische Grundlage für moderne, innovative Lösungsansätze in der Elektronik, wie beispielsweise in den Bereichen Automobil, Medizin, Sicherheits- und Messtechnik, Sport, Logistik und Unterhaltung.

Die US 2019/0161338 A1 beschreibt einen mikroelektromechanischen Aktor, der einen festen Teil und einen mobilen Teil aufweist. Die Dokumente EP 3 809 476 A1, DE 10 2017 109575 A1 und US 2008/122317 A1 beschreiben weitere Mikromechanikelemente, die teilweise Merkmale des Mikromechanikelements gemäß Anspruch 1 aufweisen.

### Offenbarung der Erfindung

Vor diesem Hintergrund werden mit dem hier vorgestellten Ansatz ein verbessertes Mikromechanikelement für einen mikroelektromechanischen

Wandler, ein verbessertes Verfahren zum Herstellen eines Mikromechanikelements, ein verbessertes Verfahren zum Betreiben eines Mikromechanikelements, weiterhin ein verbesserter mikroelektromechanischer Wandler, eine Vorrichtung, die mindestens eines der Verfahren verwendet, sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Durch den vorgestellten Ansatz wird beispielsweise eine bidirektionale quasistatische Bewegung und ein bidirektionaler Antrieb von Schwingungen ermöglicht, wodurch schnelleres Erreichen einer Zielamplitude und ein Erreichen einer größeren Maximalamplitude erzielt werden kann.

Es wird ein Mikromechanikelement für einen mikroelektromechanischen Wandler gemäß dem unabhängigen Anspruch 1 vorgestellt.

Der mikroelektromechanische Wandler kann beispielsweise als mikroelektromechanisches System (MEMS) oder als MEMS-Wandler bezeichnet werden. Das Mikromechanikelement kann als Teil des mikroelektromechanischen Wandlers ausgeformt sein und ist beispielsweise bidirektional ansteuerbar. Die Trägerschicht kann beispielsweise als ein Substrat auf Siliciumbasis ausgeformt sein. Alternativ oder zusätzlich kann die Trägerschicht auch andere Stoffe aufweisen. Die Trägerschicht kann vorteilhafterweise mindestens teilweise bidirektional verformbar sein, sodass beispielsweise eine Zielamplitude bei einer Schwingung des Wandlers schneller erreicht wird. Weiterhin kann ein Maximum der Amplitude vorteilhafterweise erhöht werden. Die Piezoelemente können jeweils zwei Elektroden aufweisen, die an einander gegenüberliegenden Seiten einer piezoelektrischen Schicht angeordnet sein können. Das bedeutet, dass beispielsweise jeweils eine Elektrode eines der Piezoelemente die Trägerschicht kontaktieren kann. Die Piezoelemente sind beispielsweise als Bauteile realisiert, durch die unter Verwendung einer elektrischen Spannung eine mechanische Bewegung ausgeführt oder bei Einwirken einer mechanischen Kraft eine elektrische Spannung produziert werden kann.

Gemäß einer Ausführungsform können das erste Piezoelement und das zweite Piezoelement versetzt zueinander oder auf einer Achse angeordnet sein, die quer zu einer Längserstreckungsachse der Trägerschicht liegt. Die Längserstreckungsachse kann beispielsweise in einem Ruhezustand des Mikromechanikelements parallel zu der neutralen Faser der Trägerschicht liegen. Die Längserstreckungsachse der Trägerschicht kann beispielsweise einer Erstreckungsrichtung der Piezoelemente entsprechen. Auf diese Weise kann ein schnelles und flexibel einstellbares Biegeverhalten der Trägerschicht realisiert werden.

Vorteilhafterweise kann das Mikromechanikelement mindestens ein weiteres erstes Piezoelement aufweisen, das auf der ersten Seite der neutralen Faser der Trägerschicht angeordnet ist. Anders ausgedrückt können die Piezoelemente zickzackartig, das bedeutet abwechselnd oberhalb und unterhalb der neutralen Faser, angeordnet sein. Der Bereich kann beispielsweise beide Seiten der neutralen Faser umfassen und zwischen zwei benachbarten Piezoelementen begrenzt sein. Eine solche Ausführungsform bietet den Vorteil einer hohen Flexibilität bei der Ausbildung oder Einstellung eines Schwingverhaltens des Mikromechanikelementes.

Gemäß einer Ausführungsform kann das erste Piezoelement und zusätzlich oder optional das zweite Piezoelement in einer Kavität in oder an der Trägerschicht angeordnet sein. Dabei kann die Kavität insbesondere eine Tiefe aufweisen, die innerhalb eines Toleranzbereichs von 100% einer Dicke des ersten und zusätzlich oder alternativ des zweiten Piezoelements entsprechen kann. Vorteilhafterweise kann durch die Tiefe der Kavität oder einer Mehrzahl von Kavitäten Bauraum effizient genutzt werden. Weiterhin können die Piezoelemente geschützt werden, da diese an mindestens drei Seiten von der Trägerschicht umgeben sein können. Die Kavitäten können also beispielsweise als Ausnehmungen realisiert sein.

Das erste und zusätzlich oder alternativ das zweite Piezoelement kann zwischen der Trägerschicht und einer Passivierungsschicht angeordnet sein. Die Passivierungsschicht kann beispielsweise durch eine chemische Reaktion mit Stoffen erzeugt werden, die sich beispielsweise von einem Material der Trägerschicht unterscheiden, oder beispielsweise von extern auf die Trägerschicht aufgebracht werden. Hierdurch können vorteilhaft Komponenten des Mikromechanikelementes gegen Umwelteinflüsse geschützt werden.

Ferner kann das Mikromechanikelement einen Stabilisierungsbereich in der Trägerschicht aufweisen, der ein anderes Biegeverhalten aufweisen kann als ein Material der Trägerschicht. Insbesondere kann der Stabilisierungsbereich dem ersten Piezoelement gegenüberliegend angeordnet sein. Vorteilhafterweise kann die Trägerschicht eine Mehrzahl von Materialien aufweisen, die sich beispielsweise in ihrer Festigkeit, Elastizität oder allgemein bezeichnet in ihrer Verformbarkeit voneinander unterscheiden können. Hierdurch kann durch eine einfache Designoption ein gewünschtes Biegeverhalten der Trägerschicht des Mikromechanikelementes eingestellt oder adaptiert werden.

Es wird weiterhin ein Verfahren zum Herstellen eines Mikromechanikelements in einer zuvor genannten Variante gemäß dem Anspruch 5 vorgestellt.

Das Verfahren kann unter Verwendung von Halbleiterprozessen durchgeführt werden, wodurch vorteilhafterweise eine gleichbleibende Präzision bei einer Ausrichtung der einzelnen Bestandteile des Mikromechanikelements erreicht werden kann. Vorteilhafterweise kann dadurch eine Langlebigkeit des Endprodukts verbessert, beziehungsweise eine Fehleranfälligkeit reduziert werden.

Gemäß einer Ausführungsform kann im Schritt des Bereitstellens ein Teilschritt des Anordnens des ersten Piezoelements in einer Kavität einer Hilfsschicht, ein Teilschritt des Abdeckens des ersten Piezoelements durch die Trägerschicht und ein Teilschritt des Aufbringens des zweiten Piezoelements auf der Trägerschicht durchgeführt werden. Vorteilhafterweise können die Piezoelemente dadurch präzise auf einer Linie übereinander angeordnet werden.

Im Schritt des Bereitstellens können gemäß einer Ausführungsform in einem Teilschritt des Anordnens das erste und das zweite Piezoelement auf einer Hilfsschicht angeordnet werden. In einem Teilschritt des Auftragens kann zumindest ein Teil der Trägerschicht auf das zweite Piezoelement aufgetragen werden, sodass das zweite Piezoelement in einer Kavität angeordnet werden kann. Vorteilhafterweise kann in einem solchen Fall das zweite Piezoelement von der Hilfsschicht auf einer Seite und von der Trägerschicht beispielsweise an drei anderen Seiten umgeben sein, sodass das zweite Piezoelement vollständig eingebettet realisiert werden kann. Vorteilhafterweise kann das zweite Piezoelement dadurch vor äußeren Einflüssen geschützt werden.

Weiterhin kann im Teilschritt des Abdeckens und zusätzlich oder alternativ im Teilschritt des Auftragens mindestens eine Kavität in oder an der Trägerschicht ausgebildet werden, um das erste und zusätzlich oder alternativ das zweite Piezoelement aufzunehmen. Genauer gesagt kann mindestens eines der Piezoelemente beispielsweise unter Verwendung von Halbleiterprozessen in der Kavität erzeugt werden.

Es wird weiterhin ein Verfahren zum Betreiben eines Mikromechanikelements, wie es zuvor genannt wurde, vorgestellt, wobei das Verfahren einen Schritt des Beaufschlagens des ersten und zusätzlich oder alternativ des zweiten Piezoelements mit einer elektrischen Spannung und zusätzlich oder alternativ einen Schritt des Erfassens einer elektrischen Spannung von dem ersten und zusätzlich oder alternativ zweiten Piezoelement umfasst.

Vorteilhafterweise kann das Mikromechanikelement dadurch schnell bidirektional gebogen werden.

Diese Verfahren können beispielsweise in Software oder Hardware oder in einer Mischform aus Software und Hardware beispielsweise in einem Steuergerät implementiert sein.

Der hier vorgestellte Ansatz schafft ferner eine Vorrichtung, die ausgebildet ist, um die Schritte einer Variante eines der hier vorgestellten Verfahren in entsprechenden Einrichtungen durchzuführen, anzusteuern bzw. umzusetzen. Auch durch diese Ausführungsvariante des Ansatzes in Form einer Vorrichtung kann die dem Ansatz zugrunde liegende Aufgabe schnell und effizient gelöst werden.

Hierzu kann die Vorrichtung zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EEPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedene Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Weiterhin wird ein mikroelektromechanischer Wandler vorgestellt, der ein Trägersubstrat und ein Mikromechanikelement in einer zuvor genannten Variante aufweist, das auf dem Trägersubstrat angeordnet ist.

Der mikroelektromechanische Wandler kann beispielsweise als Sensor oder als Aktor konfiguriert sein. Er kann als MEMS-Wandler bezeichnet werden, der ausgebildet ist, um beispielsweise mit einem Volumenstrom eines Fluids zu interagieren. Das Trägersubstrat kann beispielsweise eine Kavität aufweisen, in der das Mikromechanikelement angeordnet sein kann.

Ausführungsbeispiele des hier vorgestellten Ansatzes sind in den Zeichnungen dargestellt und in der nachfolgenden Beschreibung näher erläutert. Es zeigt:
Fig. 1 eine schematische Schnittdarstellung durch mindestens ein Mikromechanikelement gemäß einem Ausführungsbeispiel;
Fig. 2 eine schematische Schnittdarstellung eines Ausführungsbeispiels mindestens eines Mikromechanikelements;
Fig. 3 eine schematische Schnittdarstellung eines mikroelektromechanischen Wandlers gemäß einem Ausführungsbeispiel;
Fig. 4 eine schematische Schnittdarstellung eines Ausführungsbeispiels eines mikroelektromechanischen Wandlers;
Fig. 5-8 eine schematische Schnittdarstellung eines Ausführungsbeispiels eines Mikromechanikelements während eines Herstellungsprozesses;
Fig. 9-11 eine schematische Schnittdarstellung eines Ausführungsbeispiels eines Mikromechanikelements während eines Herstellungsprozesses;
Fig. 12 ein Ablaufdiagramm eines Verfahrens gemäß einem Ausführungsbeispiel zum Herstellen eines Mikromechanikelements;
Fig. 13 ein Blockschaltbild einer Vorrichtung gemäß einem Ausführungsbeispiel;
Fig. 14 ein Ablaufdiagramm eines Verfahrens gemäß einem Ausführungsbeispiel zum Betreiben eines Mikromechanikelements; und
Fig. 15 ein Blockschaltbild einer Vorrichtung gemäß einem Ausführungsbeispiel.

In der nachfolgenden Beschreibung günstiger Ausführungsbeispiele des vorliegenden Ansatzes werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

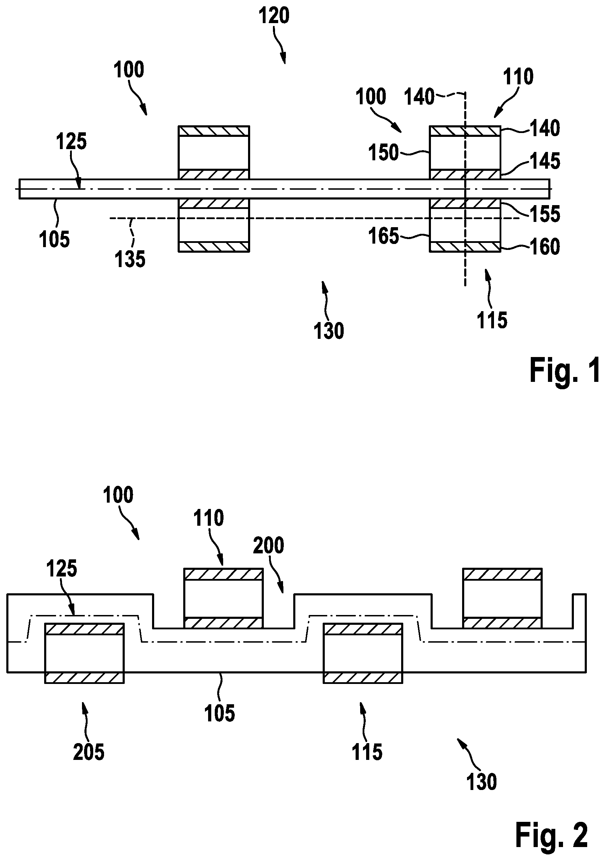

Fig. 1 zeigt eine schematische Schnittdarstellung durch mindestens ein Mikromechanikelement 100 gemäß einem Ausführungsbeispiel. Das Mikromechanikelement 100 ist beispielsweise für einen mikroelektromechanischen Wandler nutzbar, der auch als mikroelektromechanisches System (MEMS) oder verkürzt auch als MEMS-Wandler bezeichnet wird, und weist eine Trägerschicht 105 auf, die als Biegebalken oder als eine Membran ausgeformt ist. Außerdem weist das Mikromechanikelement 100 ein erstes Piezoelement 110 sowie ein zweites Piezoelement 115 auf. Das erste Piezoelement 110 ist dabei auf einer ersten Seite 120 der neutralen Faser 125 der Trägerschicht angeordnet und das zweite Piezoelement 115 auf einer zweiten Seite 130 der neutralen Faser, wobei zweite Seite 130 der ersten Seite 120 gegenüberliegt. Gemäß diesem Ausführungsbeispiel ist die Trägerschicht 105 in einem Ruhezustand dargestellt, sodass die neutrale Faser 125 parallel zu einer Erstreckungsachse 135 des Mikromechanikelements 100 verläuft. Das erste Piezoelement 110 und das zweite Piezoelement 115 sind versetzt zueinander angeordnet, wie es in der nachfolgenden Fig. 2 beschrieben wird. Alternativ sind die Piezoelemente 110, 115 auf einer Achse 140 angeordnet, die senkrecht zu der Erstreckungsachse 135 der Trägerschicht 105 verläuft. Das erste Piezoelement 110 weist gemäß diesem Ausführungsbeispiel eine erste Elektrode 140 und eine zweite Elektrode 145 auf. Zwischen den Elektroden 140, 145 ist dabei eine piezoelektrische Schicht 150 angeordnet. Analog dazu weist das zweite Piezoelement 115 eine dritte Elektrode 155 und eine vierte Elektrode 160 auf, zwischen denen eine weitere piezoelektrische Schicht 165 angeordnet ist. Gemäß diesem Ausführungsbeispiel sind ferner zwei gleichartig ausgeformte Mikromechanikelemente 100 abgebildet, die benachbart zueinander angeordnet sind und sich die Trägerschicht 105 teilen.

Anders und verkürzt ausgedrückt ist gemäß diesem Ausführungsbeispiel ein Querschnitt durch ein Mikromechanikelement 100 mit beidseitig übereinander angeordneten Piezoelementen 110, 115 in einer planaren Ausführungsform dargestellt.

Allgemein ist für Mikromechanikelemente 100 mitunter eine bidirektionale Auslenkungsmöglichkeit ausgehend von einer Ruhelage wünschenswert. Dies ermöglicht einen größeren Auslenkungshub oder einen größeren Messbereich und eine Differentialmessung eines mikroelektromechanischen Wandlers als MEMS-Sensor. Für mikroelektromechanische Wandler werden Biegebalken und Membranen für die Mikromechanikelemente 100 als MEMS-Aktoren oder - Sensoren eingesetzt. Üblicherweise wird bei piezobasierten mikroelektromechanischen Wandlern, der beispielsweise auch als PiezoMEMS, als Piezoaktor und/oder als Piezosensor bezeichnet wird, mindestens ein Piezoelement 110, 115 auf ein bewegtes Element integriert, sodass quasistatisch nur eine unidirektionale Auslenkung möglich ist. Daneben ist ein dynamischer Antrieb derart realisierbar, dass die Auslenkung durch den Piezoaktor erfolgt, während eine Bewegung in Gegenrichtung allein durch die mechanische Massenträgheit bewerkstelligt wird.

Vor diesem Hintergrund ist der beschriebene Ansatz für akustische Wandler, wie beispielsweise Mikrofone, Mikrospeaker, piezoelektrische mikrobearbeitete Ultraschallwandler *(Piezoelectric Micromachined Ultrasonic Transducer;* PMUT), aber auch für Mikrospiegel, Mikrolinsen, Bulk-Akustik-Wellen- (BAW) oder Film-Bulk-Akustik-Wellen-Resonatoren (FBAR), Radio-Frequenz-Filter (RF) und/oder Ähnliches verwendbar. Der vorgestellte Ansatz beschreibt daher das Mikromechanikelement 100. Das Mikromechanikelement 100 ist sowohl als Aktor als auch als Sensor nutzbar. Im Aktorfall lassen sich mit ihm Schwingungsbewegungen in zwei unterschiedliche Richtungen aktiv antreiben und auch quasistatische Bewegungen in zwei Richtungen aus der Ruhelage heraus durchführen.

Gemäß diesem Ausführungsbeispiel ist das Mikromechanikelement 100 als ein freistehendes, wenigstens einseitig eingespanntes, mikromechanisches, verformbares Element realisiert oder realisierbar, das die Trägerschicht 105 und zwei auf gegenüberliegenden Seiten 120, 130 diesseits und jenseits der neutralen Faser 125 der Trägerschicht 105 integrierten Piezowandlern 110, 115 aufweist, dessen Verformung kausal mit einem elektrischen Spannungssignal an den Piezowandlern 110, 115 zusammenhängt. Die Trägerschicht 105 ist beispielsweise als ein Biegebalken oder eine Membran ausgeformt. Optional ist das Mikromechanikelement 100 an zwei Seiten oder randumlaufend eingespannt und/oder weist beispielsweise Korrugationen auf, die parallel oder senkrecht zur Erstreckungsrichtung der Piezowandler 110, 115 verlaufen. Weiterhin ist das Mikromechanikelement 100 im Wesentlichen planar ausgebildet.

Das Mikromechanikelement 100 ist sowohl als Aktor als auch als Sensor nutzbar und interagiert beispielsweise mit einem Umgebungsfluid. Speziell ist es allein oder in einer Mehrzahl davon Teil eines akustischen MEMS-Wandlers, der gemäß diesem Ausführungsbeispiel als mikroelektromechanischer Wandler erwähnt und in mindestens einer der nachfolgenden Figuren näher beschrieben wird, realisiert. Im Falle einer Verwendung des Mikromechanikelements 100 als Aktor lassen sich über die Piezoelemente 110, 115 Bewegungen in zwei Richtungen alternierend aktiv antreiben, wobei das jeweils andere passive zur Bewegungserfassung nutzbar ist. Im Falle einer Verwendung des Mikromechanikelements 100 als Sensor sind die Signale der gegenüberliegenden Piezoelemente 110, 115, die auch als Piezowandler bezeichnet werden, für eine differentielle Auswertung in einem Sigma-Delta-Wandler heranziehbar. Beispielsweise ist das Mikromechanikelement 100 je nach Applikation verschieden ausformbar. Beispielsweise sind die Piezowandler 110, 115 auf den gegenüberliegenden Oberflächen der Trägerschicht 105 versetzt oder unversetzt zueinander angeordnet. Die Trägerschicht 105 ist dabei beispielsweise entweder planar oder mit Korrugation längs der Piezowandler 110, 115 ausgeführt. Die Trägerschicht 105 ist beispielsweise als Membran oder als Biegebalken ausgebildet. Das Mikromechanikelement 100 ist beispielsweise auf verschiedene Weisen an einem Substrat verankert, beispielsweise randumlaufend oder mittels einer Mehrzahl von Ankerpunkten.

Die Trägerschicht 105 ist optional elektrisch leitfähig realisierbar, sodass sie in einem solchen Fall gleichzeitig als Elektrode für eine und/oder beide Piezowandler 110, 115 nutzbar ist und die Elektroden 145, 155 optional auch entfallen können. Bevorzugt liegen die der Trägerschicht 105 zugewandten Elektroden 145, 155 auf demselben elektrischen Massepotenzial, während an den der Trägerschicht 105 abgewandten Elektroden 140, 160 Steuersignale angelegt oder abgegriffen werden.

Fig. 2 zeigt eine schematische Schnittdarstellung eines Ausführungsbeispiels mindestens eines Mikromechanikelements 100. Das dargestellte Mikromechanikelement 100 ähnelt dabei dem in Fig. 1 beschriebenen Mikromechanikelement 100. Auch hier weist das Mikromechanikelement 100 eine gemeinsame Trägerschicht 105 für beide, beziehungsweise optional auch für eine Vielzahl von Mikromechanikelementen 100 auf, die jedoch um die Piezoelemente 110, 115 herumgeschlängelt ausgeformt ist. Die neutrale Faser 125 verläuft dabei gemäß diesem Ausführungsbeispiel derart, dass sie einen möglichst gleichen Abstand zu den gemäß diesem Ausführungsbeispiel zueinander versetzten Piezoelementen 110, 115 aufweist. Gemäß diesem Ausführungsbeispiel ist das zweite Piezoelement 115 passgenau in die Trägerschicht 105 integriert. Das erste Piezoelement 110 dagegen ist in einer Kavität 200 angeordnet, die länger ausgeformt ist als das erste Piezoelement 110 und/oder als das zweite Piezoelement 115. Lediglich optional ist das zweite Piezoelement 115 ebenfalls in einer Kavität anordenbar. Die Kavität 200 weist dabei beispielsweise eine Tiefe auf, die innerhalb eines Toleranzbereichs von 100% einer Dicke des ersten Piezoelements 110 und/oder des zweiten Piezoelements 115 entspricht. Das Mikromechanikelement 100 weist gemäß diesem Ausführungsbeispiel mindestens ein weiteres zweites Piezoelement 205 auf, das auf der zweiten Seite 130 der neutralen Faser 125 der Trägerschicht 105 angeordnet ist. Insbesondere ist das erste Piezoelement 110 in einem Bereich zwischen den zweiten Piezoelementen 115, 205 angeordnet. In anderen Worten ausgedrückt ist gemäß diesem Ausführungsbeispiel ein Querschnitt durch ein Mikromechanikelement 100 mit beidseitig versetzt zueinander angeordneten Piezoelementen 110, 115 in einer korrugierten Ausführungsform dargestellt.

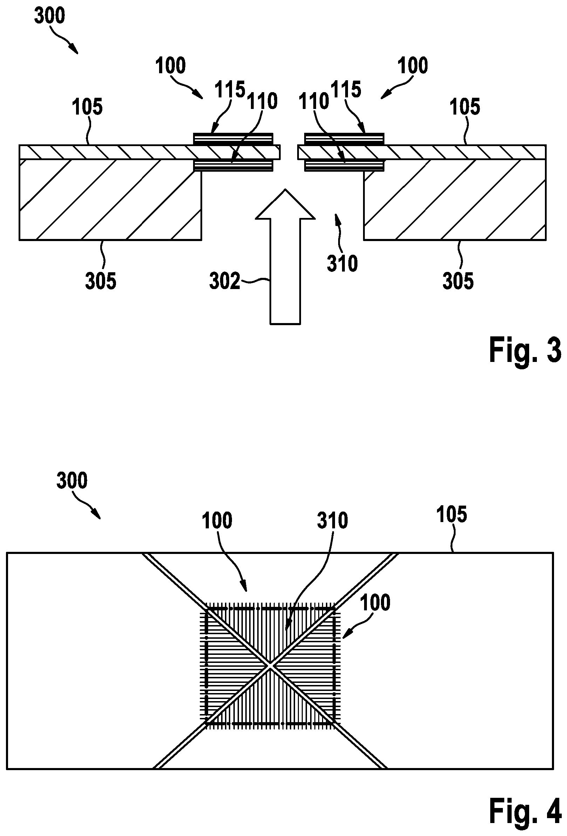

Fig. 3 zeigt eine schematische Schnittdarstellung eines mikroelektromechanischen Wandlers 300 gemäß einem Ausführungsbeispiel. Der mikroelektromechanische Wandler 300 ist beispielsweise ausgebildet, um mit einem Volumenstrom 302 eines Fluids zu interagieren und weist ein Trägersubstrat 305 sowie ein Mikromechanikelement 100 auf, wie es in einer der Figuren 1 bis 2 beschrieben wurde. Dabei ist der mikroelektromechanische Wandler 300 sowohl als Aktor als auch als Sensor konfiguriert. Gemäß diesem Ausführungsbeispiel weist der mikroelektromechanische Wandler 300 zwei gleichartige Mikromechanikelemente 100 auf, die jeweils an einer Seite mit dem Substrat 305 mittels einer Verlängerung der Trägerschicht 105 verbunden und an einer gegenüberliegenden Seite freiliegend sind. Im Bereich des Mikromechanikelements 100 weist das Trägersubstrat 305 eine Kavität 310 auf, sodass das Mikromechanikelement 100 an der freiliegenden Seite über der Kavität 310 "schwebt".

In anderen Worten ausgedrückt ist gemäß diesem Ausführungsbeispiel ein Querschnitt durch einen mikroelektromechanischen Wandler 300 dargestellt, der beispielsweise auch als MEMS-Bauelement bezeichnet wird und beidseitig angeordnete Piezoelemente 110, 115 aufweist. Der mikroelektromechanische Wandler 300, der vereinfacht auch als MEMS-Wandler 300 bezeichnet wird, weist gemäß diesem Ausführungsbeispiel das Trägersubstrat 305, eine darin ausgebildete Kavität 310 und das Mikromechanikelement 100 auf, das die Kavität 310 begrenzt und dessen Verformung entlang einer Bewegungsrichtung mit dem Volumenstrom 302 eines Fluids senkrecht zu dem Mikromechanikelement 100 kausal zusammenhängt. Der MEMS-Wandler 300 ist beispielsweise als MEMS-Sensor oder als MEMS-Aktor realisiert. Die Trägerschicht 105 ist lediglich optional elektrisch leitfähig realisiert, sodass sie beispielsweise eine Funktion mindestens einer Elektrode der Piezoelemente 110, 115 erfüllt, die beispielsweise auf demselben elektrischen Massepotenzial liegen. An den der Trägerschicht 105 abgewandt angeordneten Elektroden werden beispielsweise Steuersignale angelegt. Die Steuersignale sind idealerweise so abgestimmt, dass sich die Piezoelemente 110, 115 auf den gegenüberliegenden Seiten der Trägerschicht 105 um 180° phasenverschoben ausdehnen und/oder zusammenziehen.

Eine Zuführung oder Abführung des Fluids zum Mikromechanikelement 100 erfolgt beispielsweise über die in dem Trägersubstrat 305 ausgebildete Kavität 310. Die Verformung des Mikromechanikelements 100 erfolgt entlang der Bewegungsrichtung des Volumenstroms 302 eines Fluids, beispielsweise senkrecht zu dem Mikromechanikelement 100. Der Volumenstrom 302 wird lediglich optional durch das Mikromechanikelement 100 selbst erzeugt oder wird alternativ von außen zugeführt. In beiden Fällen ergibt sich ein kausaler Zusammenhang zwischen Volumenstrom 302 und Verformung.

Fig. 4 zeigt eine schematische Draufsichtdarstellung eines Ausführungsbeispiels eines mikroelektromechanischen Wandlers 300. Der mikroelektromechanische Wandler 300 entspricht dem in Fig. 3 beschriebenen mikroelektromechanischen Wandler 300 und weicht lediglich in einer Darstellungsart ab. Gemäß diesem Ausführungsbeispiel ist der mikroelektromechanische Wandler 300 aus der Draufsicht abgebildet. Gemäß diesem Ausführungsbeispiel ist eine Mehrzahl von Mikromechanikelementen 100 dargestellt, die gemeinsam eine viereckige, insbesondere quadratische Form darstellen und eine Kavität 310 im Wesentlichen überdecken.

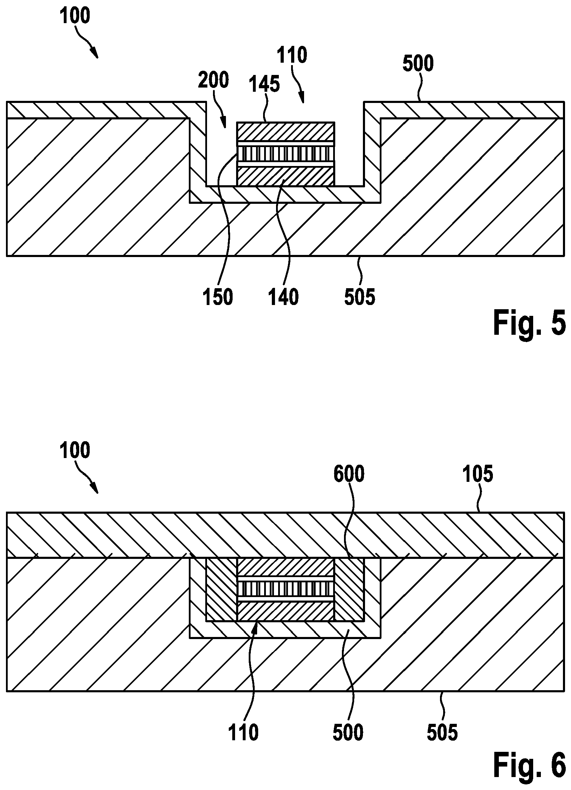

In den folgenden Figuren 5 bis 11 ist jeweils eine schematische Schnittdarstellung eines Ausführungsbeispiels eines Mikromechanikelements 100 in unterschiedliche Phasen während eines Herstellungsprozesses gezeigt.

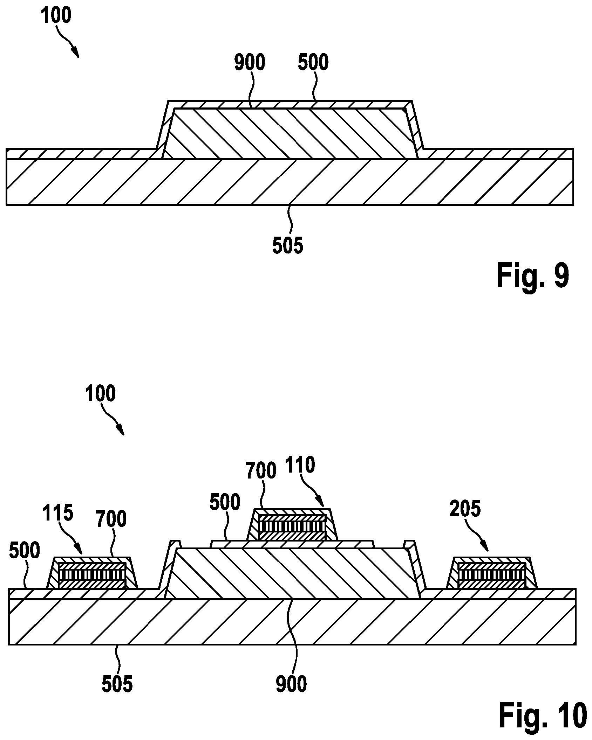

Die Figuren 5 bis 8 repräsentieren dabei eine Herstellung des Mikromechanikelements 100, wie es beispielsweise in mindestens einer der Figuren 1, 3, 4 beschrieben wurde. Die Figuren 9 bis 11 repräsentieren dagegen eine Herstellung des Mikromechanikelements 100, wie es beispielsweise in Fig. 2 beschrieben wurde.

Fig. 5 zeigt eine schematische Schnittdarstellung eines Ausführungsbeispiels eines Mikromechanikelements 100 während eines Herstellungsprozesses. Das gemäß diesem Ausführungsbeispiel dargestellte Mikromechanikelement 100 entspricht oder ähnelt beispielsweise dem in einer der Figuren 1, 3, 4 beschriebenen Mikromechanikelement 100 und repräsentiert lediglich eine Momentaufnahme während des Herstellungsprozesses. Gemäß diesem Ausführungsbeispiel ist das erste Piezoelement 110 auf einer mit einer Passivierungsschicht 500 beschichteten Hilfsschicht 505 angeordnet. Die Hilfsschicht 505 weist weiterhin eine Kavität 200 auf, in die das erste Piezoelement 110 eingesetzt ist.

Beispielsweise wird die Hilfsschicht 505 bereitgestellt und anschließend die Kavität 200 als Gräben erzeugt, deren Tiefe sich im Bereich der Dicke des Piezoelements 110 oder darüber bewegt. Nachfolgend wird eine erste Lage von Piezowandlern 110 aufgebracht und strukturiert, die jeweils die erste Elektrode 140, die zweite Elektrode 145 und die piezoelektrische Schicht 150 aufweisen.

Fig. 6 zeigt eine schematische Schnittdarstellung eines Ausführungsbeispiels eines Mikromechanikelements 100 während eines Herstellungsprozesses. Das in Fig. 6 dargestellte Mikromechanikelement 100 ähnelt dem in Fig. 5 beschriebenen Mikromechanikelement 100 und repräsentiert lediglich eine Momentaufnahme während des Herstellungsprozesses. Gegenüber dem in Fig. 5 dargestellten Mikromechanikelement 100 ist es gemäß diesem Ausführungsbeispiel weiterentwickelt. Beispielsweise wird eine Planarisierungsschicht 600 abgeschieden, um in einem optionalen Polierschritt die Substratoberfläche 605 der Hilfsschicht 505 zu planarisieren. Dabei wird beispielsweise ein Teil der Passivierungsschicht entfernt, die außerhalb der Kavität angeordnet ist. Um die Substratoberfläche 605 vollständig zu ebnen, ist gemäß diesem Ausführungsbeispiel die Trägerschicht 105 auf die Hilfsschicht 505 aufgebracht, die deckelartig fungiert. Die Trägerschicht 105 ist als mechanische Trägerschicht 105 realisiert. Gemäß diesem Ausführungsbeispiel ist das erste Piezoelement 110 zwischen der Trägerschicht 105 und der Passivierungsschicht 500 angeordnet. Zusätzlich oder alternativ ist auch ein zweites Piezoelement, zwischen der Trägerschicht 105 und der Passivierungsschicht 500 anordenbar.

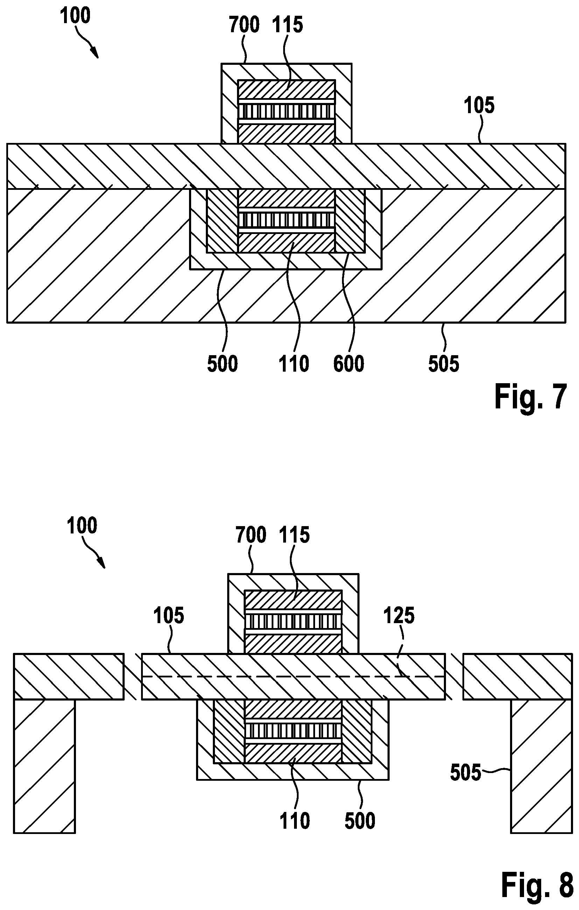

Fig. 7 zeigt eine schematische Schnittdarstellung eines Ausführungsbeispiels eines Mikromechanikelements 100 während eines Herstellungsprozesses. Das in Fig. 7 dargestellte Mikromechanikelement 100 ähnelt dem in Fig. 6 beschriebenen Mikromechanikelement 100 und repräsentiert lediglich eine Momentaufnahme während des Herstellungsprozesses. Gegenüber dem in Fig. 6 dargestellten Mikromechanikelement 100 ist es gemäß diesem Ausführungsbeispiel weiterentwickelt. Gemäß diesem Ausführungsbeispiel weist das Mikromechanikelement 100 zusätzlich zu Fig. 7 ein zweites Piezoelement 115 auf, das von einer weiteren Passivierungsschicht 700 ummantelt ist.

Fig. 8 zeigt eine schematische Schnittdarstellung eines Ausführungsbeispiels eines Mikromechanikelements 100 während eines Herstellungsprozesses. Das in Fig. 8 dargestellte Mikromechanikelement 100 ähnelt dem in Fig. 7 beschriebenen Mikromechanikelement 100 und repräsentiert lediglich eine Momentaufnahme während des Herstellungsprozesses. Gegenüber dem in Fig. 7 dargestellten Mikromechanikelement 100 ist es gemäß diesem Ausführungsbeispiel weiterentwickelt dargestellt. Gemäß diesem Ausführungsbeispiel ist die Hilfsschicht 505 strukturiert, sodass das erste Piezoelement 110 samt Passivierungsschicht 500 freigelegt ist. Zusätzlich ist die Trägerschicht 105 auf mindestens einer Seite des Mikromechanikelements 100 durchgetrennt.

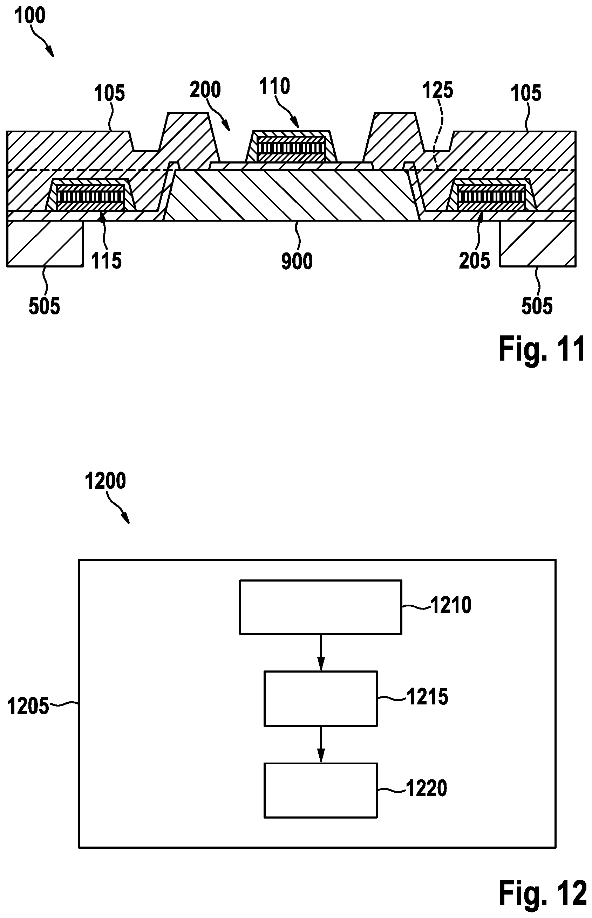

Fig. 9 zeigt eine schematische Schnittdarstellung eines Ausführungsbeispiels eines Mikromechanikelements 100 während eines Herstellungsprozesses. Genauer gesagt ist gemäß diesem Ausführungsbeispiel lediglich eine Momentaufnahme während des Herstellungsprozesses abgebildet. Das herzustellende Mikromechanikelement 100 entspricht oder ähnelt dabei dem in Fig. 2 beschriebenen Mikromechanikelement 100. Gemäß diesem Ausführungsbeispiel ist angrenzend an die Hilfsschicht 505 ein Stabilisierungsbereich 900 ausgeformt, der ein anderes Biegeverhalten aufweisen kann als ein Material der Trägerschicht, die in Fig. 11 aufgebracht wird. Entlang einer Oberfläche der Hilfsschicht 505 und dem Stabilisierungsbereich 900 ist dabei eine Passivierungsschicht 500 angeordnet, sodass der Stabilisierungsbereich 900 zwischen der Hilfsschicht 505 und der Passivierungsschicht 500 angeordnet ist. Die Passivierungsschicht 500 ist beispielsweise als eine trapezförmige Erhebung ausgeformt.

Anders ausgedrückt ist in Fig. 9 ein Ergebnis dargestellt, das aus einem Bereitstellen der Hilfsschicht 505, einem Abscheiden und Strukturieren des Stabilisierungsbereichs 900 sowie aus einem Abscheiden der Passivierungsschicht 500 resultiert.

Fig. 10 zeigt eine schematische Schnittdarstellung eines Ausführungsbeispiels eines Mikromechanikelements 100 während eines Herstellungsprozesses. Das in Fig. 10 dargestellte Mikromechanikelement 100 ähnelt dem in Fig. 9 beschriebenen Mikromechanikelement 100 und repräsentiert lediglich eine Momentaufnahme während des Herstellungsprozesses. Gegenüber dem in Fig. 9 dargestellten Mikromechanikelement 100 ist es gemäß diesem Ausführungsbeispiel weiterentwickelt dargestellt. Gemäß diesem Ausführungsbeispiel ist ein erstes Piezoelement 110 und mindestens ein zweites Piezoelement 115 auf der Passivierungsschicht 500 angeordnet. Genauer gesagt ist das erste Piezoelement 110 dem Stabilisierungsbereich 900 gegenüberliegend angeordnet. Der Stabilisierungsbereich kann dabei ein anderes oder ein gleiches Biegeverhalten aufweisen als ein Material einer Trägerschicht, wie sie beispielsweise in Fig. 11 beschrieben wird. Es ist jedoch auch möglich, dass der Stabilisierungsbereich aus demselben Material in derselben Dicke wie die Trägerschicht gebildet wird. Gemäß der Erfindung weist das Mikromechanikelement 100 ein weiteres zweites Piezoelement 205 auf, das auf einer Linie mit dem zweiten Piezoelement 115 liegt. Das erste Piezoelement 110 ist demnach höhenversetzt zu den zweiten Piezoelementen 115, 205 und gegenüber dem Stabilisierungsbereich 900 angeordnet. Gemäß diesem Ausführungsbeispiel ist die Passivierungsschicht 500 im Bereich des Stabilisierungsbereichs 900 geöffnet und somit nicht mehr mit den zweiten Piezoelementen 115, 205 verbunden. Um die Piezoelemente 110, 115, 205 herum ist zusätzlich eine weitere Passivierungsschicht 700 angeordnet. Ein Vorteil dieses Herstellprozesses ist, dass die Piezoelemente beidseits der neutralen Faser mit denselben Prozessschritten simultan erzeugt werden können.

Fig. 11 zeigt eine schematische Schnittdarstellung eines Ausführungsbeispiels eines Mikromechanikelements 100 während eines Herstellungsprozesses. Das in Fig. 11 dargestellte Mikromechanikelement 100 ähnelt dem in Fig. 10 beschriebenen Mikromechanikelement 100 und repräsentiert lediglich eine Momentaufnahme während des Herstellungsprozesses. Gegenüber dem in Fig. 10 dargestellten Mikromechanikelement 100 ist es gemäß diesem Ausführungsbeispiel weiterentwickelt dargestellt. Dabei ist die Trägerschicht 105 aufgebracht, sodass die zweiten Piezoelemente 115, 205 vollständig in die Trägerschicht 105 integriert sind. Das erste Piezoelement 110 ist gemäß diesem Ausführungsbeispiel in einer Kavität 200 angeordnet und somit nicht von der Trägerschicht 105 umgeben. Weiterhin ist die Hilfsschicht 505 gemäß diesem Ausführungsbeispiel strukturiert dargestellt, sodass der Stabilisierungsbereich 900 freiliegt und eine Biegsamkeit des Mikromechanikelements 100 möglich ist. An einer dem Stabilisierungsbereich 900 abgewandten Seite der Trägerschicht 105 ist diese lediglich beispielhaft strukturiert ausgeformt. Gemäß diesem Ausführungsbeispiel verläuft die neutrale Faser 125 des Mikromechanikelements 100 längs durch die Trägerschicht 105 zwischen dem ersten Piezoelement 110 und den zweiten Piezoelementen 115, 205 und beispielsweise entlang einer Oberkante des Stabilisierungsbereichs 900.

Fig. 12 zeigt ein Ablaufdiagramm eines Verfahrens 1200 gemäß einem Ausführungsbeispiel zum Herstellen eines Mikromechanikelements. Unter Verwendung des Verfahrens 1200 wird beispielsweise ein Mikromechanikelement hergestellt, wie es in einer der Figuren 1 bis 11 beschrieben wurde. Das Verfahren 1200 umfasst dazu einen Schritt 1205 des Bereitstellens einer Trägerschicht, die als Biegebalken oder Membran ausgeformt ist. Auf der Trägerschicht ist ein erstes Piezoelement auf einer ersten Seite der neutralen Faser angeordnet. Weiterhin ist ein zweites Piezoelement vorgesehen, das auf einer zweiten Seite der neutralen Faser der Trägerschicht angeordnet ist, wobei zweite Seite der ersten Seite gegenüberliegt, um das Mikromechanikelement herzustellen. Lediglich optional umfasst das Verfahren 1200, genauer gesagt der Schritt 1205 des Bereitstellens einen Teilschritt 1210 des Anordnens, in dem das erste Piezoelement in einer Kavität einer Hilfsschicht angeordnet ist. In einem Teilschritt 1215 des Abdeckens wird das erste Piezoelement durch die Trägerschicht abgedeckt und folglich wird in einem Teilschritt 1220 des Aufbringens das zweite Piezoelement auf die Trägerschicht aufgebracht.

In anderen Worten ausgedrückt wird beispielsweise die Hilfsschicht bereitgestellt sowie eine erste Lage von Piezowandlern bestehend aus einer unteren Passivierungsschicht, einer ersten Elektrode, einer piezoelektrischen Schicht, einer zweiten Elektrode und einer oberen Passivierungsschicht aufgebracht und/oder strukturiert. Die mechanische Trägerschicht wird anschließend aufgebracht und/oder strukturiert. Weiterhin wird beispielsweise eine Kavität oder Freistellung des bidirektionalen mikromechanischen Elements erzeugt. Lediglich optional ist ein Strukturieren der Trägerschicht und/oder ein Aufbringen und Strukturieren einer zweiten Lage von Piezowandlern denkbar. Vor dem Aufbringen der ersten Piezolage werden ferner beispielhaft im Substrat, das bedeutet in der Hilfsschicht, Gräben für die auch als Piezos bezeichneten Piezoelemente erzeugt, deren Tiefe sich im Bereich der Dicke der Piezowandler oder darüber bewegt. Anschließend wird weiterhin optional vor oder nach dem Aufbringen der mechanischen Trägerschicht ein chemisch-mechanischer Polierschritt zum Planarisieren des Substrats durchgeführt.

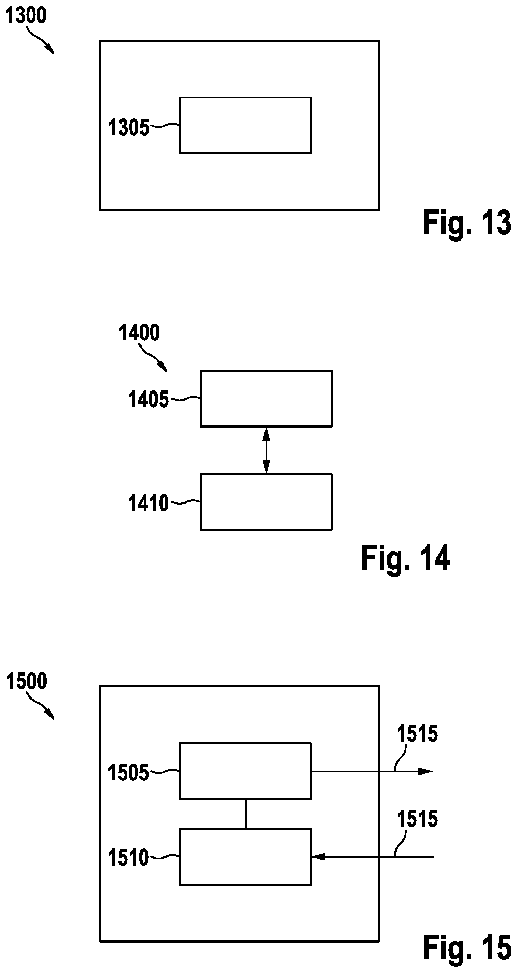

Fig. 13 zeigt ein Blockschaltbild einer Vorrichtung 1300 gemäß einem Ausführungsbeispiel. Die Vorrichtung 1300 ist ausgebildet, um ein Verfahren zum Herstellen eines Mikromechanikelements anzusteuern oder durchzuführen, wie es beispielsweise in Fig. 12 beschrieben wurde. Die Vorrichtung 1300 ist beispielsweise als ein Steuergerät realisierbar oder in einem Steuergerät implementierbar und weist eine Bereitstelleinheit 1305 auf. Die Bereitstelleinheit 1305 ist ausgebildet, um eine Trägerschicht bereitzustellen, die als Biegebalken oder Membran ausgeformt ist, wobei auf der Trägerschicht ein erstes Piezoelement angeordnet ist, das auf einer ersten Seite der neutralen Faser der Trägerschicht angeordnet ist, und ein zweites Piezoelement vorgesehen ist, das auf einer zweiten Seite der neutralen Faser der Trägerschicht angeordnet ist.

Dabei liegt zweite Seite der ersten Seite gegenüber, um das Mikromechanikelement herzustellen.

Fig. 14 zeigt ein Ablaufdiagramm eines Verfahrens 1400 gemäß einem Ausführungsbeispiel zum Betreiben eines Mikromechanikelements. Das Verfahren 1400 wird für Mikromechanikelemente durchgeführt oder angesteuert, wie sie beispielsweise in mindestens einer der Figuren 1 bis 11 beschrieben wurden. Das Verfahren 1400 umfasst dabei einen Schritt 1405 des Beaufschlagens des ersten und/oder zweiten Piezoelements mit einer elektrischen Spannung und/oder einen Schritt 1410 des Erfassens einer elektrischen Spannung von dem ersten und/oder zweiten Piezoelement.

Fig. 15 zeigt ein Blockschaltbild einer Vorrichtung 1500 gemäß einem Ausführungsbeispiel. Die Vorrichtung 1500 ist ausgebildet, um ein Verfahren zum Betreiben eines Mikromechanikelements anzusteuern oder durchzuführen, wie es beispielsweise in Fig. 14 beschrieben wurde. Die Vorrichtung 1500 ist beispielsweise als ein Steuergerät realisierbar oder in einem Steuergerät implementierbar und weist eine Beaufschlagungseinheit 1505 und/oder eine Erfassungseinheit 1510 auf. Die Beaufschlagungseinheit 1505 ist dabei ausgebildet, um das erste und/oder das zweite Piezoelements mit einer elektrischen Spannung 1515 zu beaufschlagen. Die Erfassungseinheit 1510 ist ausgebildet, um eine elektrische Spannung 1515 von dem zweiten und/oder ersten Piezoelement zu erfassen.

Die hier vorgestellten Verfahrensschritte können wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Mikromechanikelement (100) für einen mikroelektromechanischen Wandler (300), wobei das Mikromechanikelement (100) die folgenden Merkmale aufweist:
eine Trägerschicht (105), die als Biegebalken oder Membran ausgeformt ist;
ein erstes Piezoelement (110), das auf einer ersten Seite (120) einer neutralen Faser (125) der Trägerschicht (105) angeordnet ist; und
ein zweites Piezoelement (115), das auf einer zweiten Seite (130) der neutralen Faser (125) der Trägerschicht (105) angeordnet ist, wobei die zweite Seite (130) der ersten Seite (120) gegenüberliegt,
wobei mindestens ein weiteres zweites Piezoelement (115) vorliegt, das auf der zweiten Seite (130) der neutralen Faser (125) der Trägerschicht (105) angeordnet ist, **dadurch gekennzeichnet, dass** das erste Piezoelement (110) in einem Bereich zwischen den zweiten Piezoelementen (115) angeordnet ist.

2. Mikromechanikelement (100) gemäß Anspruch 1, wobei das erste Piezoelement (110) und eines der zweiten Piezoelemente (115) versetzt zueinander oder auf einer Achse (140) angeordnet sind, die senkrecht zu einer Längserstreckungsachse (135) der Trägerschicht (105) liegt.

3. Mikromechanikelement (100) gemäß einem der vorangegangenen Ansprüche, wobei das erste Piezoelement (110) und eines der zweiten Piezoelemente (115) in einer Kavität (200) in oder an der Trägerschicht (105) angeordnet ist, insbesondere wobei die Kavität (200) eine Tiefe aufweist, die innerhalb eines Toleranzbereichs von 100% einer Dicke des ersten Piezoelements (110) und eines des zweiten Piezoelements (115) entspricht.

4. Mikromechanikelement (100) gemäß einem der vorangegangenen Ansprüche, wobei das erste Piezoelement (110) und eines der zweiten Piezoelemente (115) zwischen der Trägerschicht (105) und einer Passivierungsschicht (500) angeordnet ist.

5. Verfahren (1200) zum Herstellen eines Mikromechanikelements (100) gemäß einem der vorangegangenen Ansprüche 1 bis 4, wobei das Verfahren (1200) die folgenden Schritte umfasst:
Bereitstellen (1205) einer Trägerschicht (105), die als Biegebalken oder Membran ausgeformt ist, wobei auf der Trägerschicht (105) ein erstes Piezoelement (110) angeordnet ist, das auf einer ersten Seite (120) einer neutralen Faser (125) der Trägerschicht (105) angeordnet ist, und ein zweites Piezoelement (115) vorgesehen ist, das auf einer zweiten Seite (130) der neutralen Faser (125) der Trägerschicht (105) angeordnet ist, wobei die zweite Seite (130) der ersten Seite (120) gegenüberliegt, um das Mikromechanikelement (100) herzustellen, wobei ein weiteres zweites Piezoelement (205) vorgesehen ist, das auf der zweiten Seite (130) der neutralen Faser (125) der Trägerschicht (105) angeordnet ist, **dadurch gekennzeichnet, dass** das erste Piezoelement (110) in einem Bereich zwischen den zweiten Piezoelementen (115, 205) angeordnet wird.

6. Verfahren (1200) gemäß Anspruch 5, wobei im Schritt (1205) des Bereitstellens ein Teilschritt (1210) des Anordnens des ersten Piezoelements (110) in einer Kavität (200) einer Hilfsschicht (505), ein Teilschritt (1215) des Abdeckens des ersten Piezoelements (110) durch die Trägerschicht (105) und ein Teilschritt (1220) des Aufbringens eines der zweiten Piezoelemente (115) auf die Trägerschicht (105) durchgeführt wird.

7. Verfahren (1200) gemäß des Anspruchs 6, wobei im Teilschritt (1215) des Abdeckens und/oder im Teilschritt (1220) des Auftragens mindestens eine Kavität (200) in oder an der Trägerschicht (105) ausgebildet wird, um das erste Piezoelement (110) und eines der zweiten Piezoelemente (115) aufzunehmen.

8. Mikroelektromechanischer Wandler (300), der die folgenden Merkmale aufweist:
ein Trägersubstrat (305); und
ein Mikromechanikelement (100) gemäß einem der Ansprüche 1 bis 4,
das auf dem Trägersubstrat (305) angeordnet ist.

## Claims

1. Micromechanical element (100) for a microelectromechanical transducer (300), wherein the micromechanical element (100) has the following features:
a carrier layer (105), which is designed as a bending beam or membrane;
a first piezo element (110), which is arranged on a first side (120) of a neutral fibre (125) of the carrier layer (105); and
a second piezo element (115), which is arranged on a second side (130) of the neutral fibre (125) of the carrier layer (105), wherein the second side (130) is situated opposite the first side (120),
wherein there is at least one further second piezo element (115), which is arranged on the second side (130) of the neutral fibre (125) of the carrier layer (105), **characterized in that** the first piezo element (110) is arranged in a region between the second piezo elements (115).

2. Micromechanical element (100) according to Claim 1, wherein the first piezo element (110) and one of the second piezo elements (115) are arranged offset with respect to each other or on an axis (140) which lies perpendicular to a longitudinal extension axis (135) of the carrier layer (105).

3. Micromechanical element (100) according to either of the preceding claims, wherein the first piezo element (110) and one of the second piezo elements (115) is arranged in a cavity (200) in or on the carrier layer (105), in particular wherein the cavity (200) has a depth which corresponds to a thickness of the first piezo element (110) and one of the second piezo elements (115) within a tolerance range of 100%.

4. Micromechanical element (100) according to any of the preceding claims, wherein the first piezo element (110) and one of the second piezo elements (115) is arranged between the carrier layer (105) and a passivation layer (500).

5. Method (1200) for producing a micromechanical element (100) according to any of the preceding Claims 1 to 4, wherein the method (1200) comprises the following steps:
providing (1205) a carrier layer (105), which is designed as a bending beam or membrane, wherein a first piezo element (110), which is arranged on a first side (120) of a neutral fibre (125) of the carrier layer (105), is arranged and a second piezo element (115), which is arranged on a second side (130) of the neutral fibre (125) of the carrier layer (105), is provided on the carrier layer (105), wherein the second side (130) is situated opposite the first side (120) in order to produce the micromechanical element (100), wherein a further second piezo element (205) is provided, which is arranged on the second side (130) of the neutral fibre (125) of the carrier layer (105), **characterized in that** the first piezo element (110) is arranged in a region between the second piezo elements (115, 205).

6. Method (1200) according to Claim 5, wherein a sub-step (1210) of arranging the first piezo element (110) in a cavity (200) of an auxiliary layer (505), a sub-step (1215) of covering the first piezo element (110) by the carrier layer (105) and a sub-step (1220) of applying one of the second piezo elements (115) to the carrier layer (105) are carried out in the providing step (1205).

7. Method (1200) according to Claim 6, wherein at least one cavity (200) is formed in or on the carrier layer (105) in the covering sub-step (1215) and/or in the application sub-step (1220) in order to receive the first piezo element (110) and one of the second piezo elements (115).

8. Microelectromechanical transducer (300), which has the following features:
a carrier substrate (305); and
a micromechanical element (100) according to any of Claims 1 to 4, which is arranged on the carrier substrate (305).

## Revendications

1. Elément micromécanique (100) pour un transducteur micro-électromécanique (300), l'élément micromécanique (100) comportant les caractéristiques suivantes :
une couche de support (105) qui se présente sous la forme d'une poutre de flexion ou d'une membrane ;
un premier élément piézoélectrique (110), qui est disposé sur un premier côté (120) d'une fibre neutre (125) de la couche de support (105) ; et
un deuxième élément piézoélectrique (115), qui est disposé sur un deuxième côté (130) de la fibre neutre (125) de la couche de support (105), le deuxième côté (130) faisant face au premier côté (120),
au moins un deuxième élément piézoélectrique (115) supplémentaire étant présent, qui est disposé sur le deuxième côté (130) de la fibre neutre (125) de la couche de support (105), **caractérisé en ce que** le premier élément piézoélectrique (110) est disposé dans une zone entre les deuxièmes éléments piézoélectriques (115).

2. Elément micromécanique (100) selon la revendication 1, le premier élément piézoélectrique (110) et un des deuxièmes éléments piézoélectriques (115) étant disposés avec un décalage l'un par rapport à l'autre ou sur un axe (140) qui est perpendiculaire à un axe d'extension longitudinal (135) de la couche de support (105).

3. Elément micromécanique (100) selon l'une des revendications précédentes, le premier élément piézoélectrique (110) et un des deuxièmes éléments piézoélectriques (115) étant disposés dans une cavité (200) dans ou sur la couche de support (105), en particulier la cavité (200) présentant une profondeur, qui correspond, dans une plage de tolérance de 100 %, à une épaisseur du premier élément piézoélectrique (110) et d'un des deuxièmes éléments piézoélectriques (115).

4. Elément micromécanique (100) selon l'une des revendications précédentes, le premier élément piézoélectrique (110) et un des deuxièmes éléments piézoélectriques (115) étant disposés entre la couche de support (105) et une couche de passivation (500).

5. Procédé (1200) de fabrication d'un élément micromécanique (100) selon l'une des revendications précédentes 1 à 4, le procédé (1200) comprenant les étapes suivantes :
fourniture (1205) d'une couche de support (105) qui se présente sous la forme d'une poutre de flexion ou d'une membrane, un premier élément piézoélectrique (110), qui est disposé sur un premier côté (120) d'une fibre neutre (125) de la couche de support (105), étant disposé sur la couche de support (105), et un deuxième élément piézoélectrique (115), qui est disposé sur un deuxième côté (130) de la fibre neutre (125) de la couche de support (105), étant prévu, le deuxième côté (130) faisant face au premier côté (120) pour fabriquer l'élément micromécanique (100), un deuxième élément piézoélectrique (205) supplémentaire étant prévu, qui est disposé sur le deuxième côté (130) de la fibre neutre (125) de la couche de support (105), **caractérisé en ce que** le premier élément piézoélectrique (110) est disposé dans une zone entre les deuxièmes éléments piézoélectriques (115, 205).

6. Procédé (1200) selon la revendication 5, une sous-étape (1210) de disposition du premier élément piézoélectrique (110) dans une cavité (200) d'une couche auxiliaire (505), une sous-étape (1215) de recouvrement du premier élément piézoélectrique (110) par la couche de support (105) et une sous-étape (1220) d'application d'un des deuxièmes éléments piézoélectriques (115) sur la couche de support (105) étant effectuées dans l'étape (1205) de la fourniture.

7. Procédé (1200) selon la revendication 6, au moins une cavité (200) étant formée dans ou sur la couche de support (105) dans la sous-étape (1215) du recouvrement et/ou dans la sous-étape (1220) de l'application pour recevoir le premier élément piézoélectrique (110) et un des deuxièmes éléments piézoélectriques (115).

8. Transducteur micro-électromécanique (300), qui présente les caractéristiques suivantes :
un substrat de support (305) ; et
un élément micromécanique (100) selon l'une des revendications 1 à 4, qui est disposé sur le substrat de support (305).
